# EUROPÄISCHE PATENTSCHRIFT

(11) **EP 1 713 945 B1**
(45) Veröffentlichungstag und Bekanntmachung des Hinweises auf die Patenterteilung: **04.07.2012**
(21) Anmeldenummer: 04816276.2
(22) Anmeldetag: 22.12.2004
(51) Int. Cl.: C22C 49/11, C22C 47/00, C23C 14/04, C22C 47/04

(54) **VERFAHREN ZUR HERSTELLUNG EINES HALBZEUGS AUS EINEM FASERVERSTÄRKTEM VERBUNDWERKSTOFF**
METHOD FOR PRODUCING A SEMIFINISHED PRODUCT FROM A COMPOSITE MATERIAL
PROCEDE DE FABRICATION D'UN SEMI-PRODUIT DE MATERIAU COMPOSITE

(30) Priorität: 12.01.2004 DE 102004001644
(43) Veröffentlichungstag der Anmeldung: 25.10.2006
(73) Patentinhaber: MTU Aero Engines GmbH, 80995 München (DE)
(72) Erfinder: KOPPERGER, Bertram, 85221 Dachau (DE); ROSSMANN, Axel, 85757 Karlsfeld (DE); SAGEL, Alexander, 73262 Lenningen (DE)
(86) Internationale Anmeldenummer: PCT/DE2004/002797
(87) Internationale Veröffentlichungsnummer: WO 2005/066382

(56) Entgegenhaltungen:
- DE-C1- 4 324 755
- US-A- 4 915 908
- US-A- 5 876 659
- PATENT ABSTRACTS OF JAPAN Bd. 015, Nr. 112 (C-0815), 18. März 1991 (1991-03-18) & JP 03 002338 A (SUMITOMO ELECTRIC IND LTD), 8. Januar 1991 (1991-01-08)

## Beschreibung

Die Erfindung betrifft ein Verfahren zur Herstellung eines Halbzeugs aus Verbundwerkstoff gemäß dem Oberbegriff des Anspruchs 1.

Moderne Gasturbinen, insbesondere Flugtriebwerke, müssen höchsten Ansprüchen im Hinblick auf Zuverlässigkeit, Gewicht, Leistung, Wirtschaftlichkeit und Lebensdauer gerecht werden. In den letzten Jahrzehnten wurden insbesondere auf dem zivilen Sektor Flugtriebwerke entwickelt, die den obigen Anforderungen voll gerecht werden und ein hohes Maß an technischer Perfektion erreicht haben. Bei der Entwicklung von Flugtriebwerken spielt unter anderem die Werkstoffauswahl sowie die Suche nach neuen, geeigneten Werkstoffen eine entscheidende Rolle.

Die wichtigsten, heutzutage für Flugtriebwerke oder sonstige Gasturbinen verwendeten Werkstoffe sind Titanlegierungen, Nickellegierungen (auch Superlegierungen genannt) und hochfeste Stähle. Die hochfesten Stähle werden insbesondere für Wellenteile und Getriebeteile und für Verdichtergehäuse sowie Turbinengehäuse verwendet. Titanlegierungen sind typische Werkstoffe für Verdichterteile, Nickellegierungen sind für die heißen Teile des Flugtriebwerks geeignet.

Eine sehr vielversprechende Gruppe eines neuen Werkstoffs für künftige Generationen von Flugtriebwerken sind sogenannte faserverstärkte Verbundwerkstoffe. Moderne Verbundwerkstoffe verfügen über ein Trägermaterial, welches als eine Polymer-, eine Metall- oder eine Keramikmatrix ausgebildet sein kann, sowie über in das Trägermaterial eingebettete Fasern. Die hier vorliegende Erfindung betrifft einen Verbundwerkstoff, bei welchem das Trägermaterial als Metallmatrix ausgebildet ist. Einen derartigen Werkstoff bezeichnet man auch als Metallmatrix-Verbundwerkstoff - kurz MMC genannt.

Bei hochfesten MMC-Werkstoffen, bei denen Titan als Trägermaterial zum Einsatz kommt, kann das Gewicht von Bauteilen um bis zu 50 % gegenüber herkömmlichen Titanlegierungen reduziert werden. Als Verstärkungen werden Fasern mit hoher Festigkeit und hohem Elastizitätsmodul verwendet.

Mit den aus dem Stand der Technik bekannten MMC-Werkstoffen lassen sich bereits gewichtsreduzierte Bauteile mit guten Festigkeitseigenschaften bereitstellen. Die aus dem Stand der Technik bekannten MMC-Werkstoffe verfügen jedoch über den Nachteil, dass dieselben insbesondere bei transversalen Belastungen bzw. allgemeiner unter Torsionsbelastungen keine ausreichende Festigkeit aufweisen, um die bei Gasturbinen auftretenden, hohen Belastungen mit ausreichender Sicherheit aufzunehmen bzw. abzufangen. Bislang sind aus dem Stand der Technik keine MMC-Werkstoffe, insbesondere keine MMC-Werkstoffe auf Basis von Titan oder einer Titanlegierung bekannt, die eine ausreichende Festigkeit bei transversalen Belastungen oder Torsionsbelastungen aufweisen.

Das Dokument DE 43 24 755 C1 betrifft ein Verfahren zur Herstellung von faserverstärkten Triebwerkskomponenten unter Verwendung von langen bis "endlosen" Siliziumkarbidfasern. Diese werden mit einer Matrix aus einer Titanbasislegierung beschichtet und auf eine zylindrische oder ringförmige Vorform der Triebwerkskomponente gewickelt. Nach dem Aufbringen weiterer Matrixlegierung auf die Oberfläche der bewickelten Vorform erfolgt ein heißisostatisches Pressen. Ein Anwendungsbeispiel sind Triebwerkswellen.

Aus dem Dokument US-A-4 915 908 ist ein Verfahren zur Herstellung von u.a. einer faserverstärkten Triebwerkswelle bekannt, wobei SiC-Langfasem zur Verstärkung der Torsionssteifigkeit in ein Matrixmetall eingebracht werden, z.B. in Titan (Ti). Zur Erhöhung der Festigkeitseigenschaften des Matrixmetalles selbst wird in diesem in situ eine zweite Phase, vorzugsweise eine keramische Phase durch Temperatureinwirkung ausgeschieden.

Hiervon ausgehend liegt der vorliegenden Erfindung die Aufgabe zu Grunde, ein alternatives Verfahren zur Herstellung von faserverstärkten Verbundwerkstoffen auf Ti-Basis mit verbesserter Torsionsfestigkeit herzuleiten.

Diese Aufgabe wird durch ein Verfahren nach Patentanspruch 1 gelöst. Erfindungsgemäß wird die Beschichtung der Fasern unter einer Stickstoffatmosphäre durchgeführt, wobei keramische Partikel in Form von Titannitriden in die Beschichtung eingelagert werden.

Mit der hier vorliegenden Erfindung wird erstmals vorgeschlagen, zur Steigerung der Festigkeit eines MMC-Halbzeugs gegenüber Torsionsbeanspruchung bzw. Transversalbeanspruchung keramische Partikel, die vorzugsweise eine Größe im Mikrometerbereich bis Nanometerbereich aufweisen, während der Faserbeschichtung in das metallische Matrixmaterial aus Titan oder einer Titanbasislegierung einzulagern. Mit derartigen Halbzeugen aus Verbundwerkstoff lassen sich auch für Gasturbinen Bauteile mit einer ausreichenden Festigkeit gegenüber diesem Beanspruchungskollektiv herstellen. Eine bevorzugte Verwendung liegt in der Herstellung von Wellen für Flugtriebwerke aus dem erfindungsgemäßen Halbzeug.

Bevorzugte Weiterbildungen der Erfindung ergeben sich aus dem Unteranspruch und der nachfolgenden Beschreibung. Ein Ausführungsbeispiel der Erfindung wird, ohne hierauf beschränkt zu sein, an Hand der Zeichnung näher erläutert. Dabei zeigen:
- Fig. 1: einen schematisierten Querschnitt durch ein Halbzeug;
- Fig. 2: ein vergrößertes Detail des Halbzeugs im Bereich des Trägermaterials; und
- Fig. 3: eine beschichtete Faser zur Herstellung des Halbzeugs.

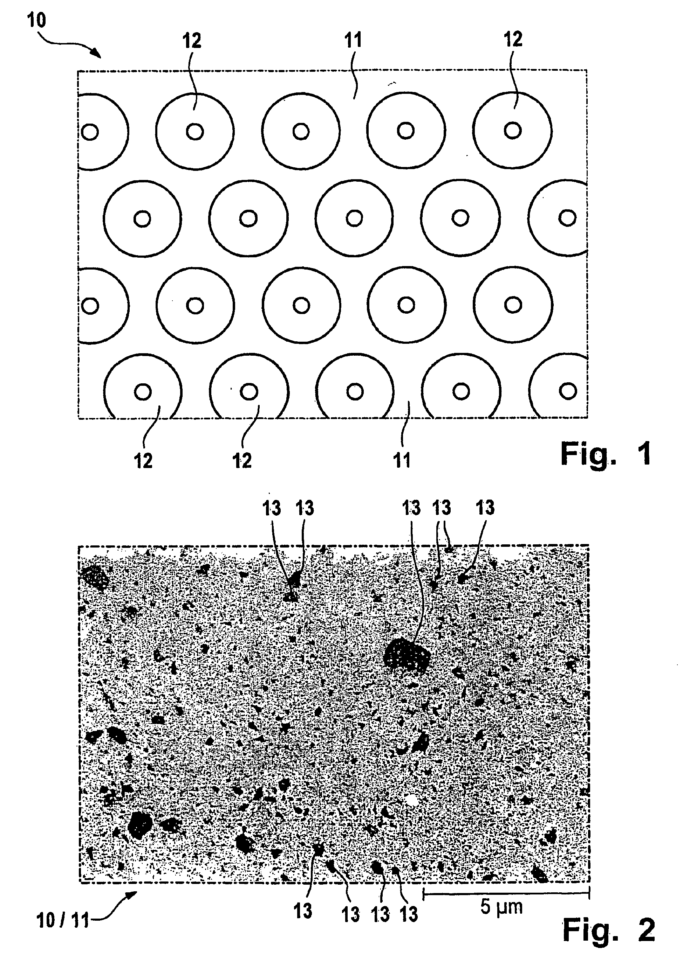

Fig. 1 zeigt einen schematisierten Ausschnitt aus einem Halbzeug 10, wobei das Halbzeug 10 aus einem metallischen Matrixmaterial 11 und aus in das Matrixmaterial 11 eingebetteten, zugfesten Fasern 12 gebildet ist. Wie Fig. 1 entnommen werden kann, sind die Fasern 12 mit einem hohen geometrischen Ordnungsgrad innerhalb des Matrixmaterials 11 positioniert.

Bei dem metallischen Matrixmaterial 11 handelt es sich um Titan oder um eine Titanbasislegierung. Als zugfeste Fasern finden bevorzugt Siliziumcarbidfasern (SiC-Fasern) Verwendung. Es können jedoch andere Fasern als Verstärkungsfasern verwendet werden, wobei die Verstärkungsfasern im Wesentlichen die Elemente Silizium, Kohlenstoff, Bor, Sauerstoff, Aluminium und/oder Stickstoff aufweisen.

Zur Erhöhung bzw. Steigerung der Festigkeit des Halbzeugs 10 gegenüber Torsionsbeanspruchung oder Transversalbeanspruchung sind keramische Partikel 13 in das metallische Matrixmaterial aus Titan oder der Titanbasislegierung eingelagert. Fig. 2 zeigt ein vergrößertes Detail aus dem Matrixmaterial 11 des Halbzeugs 10, wobei es sich bei den dunklen Partikeln um die eingelagerten, keramischen Partikel 13 und bei den hellen Partikeln um das Material der Matrix, also um Titan oder eine Titanbasislegierung, handelt. Der in Fig. 2 dargestellten Maßstabsskala kann entnommen werden, dass die in das Matrixmaterial 11 eingelagerten, keramischen Partikel 13 eine Größe im Mikrometerbereich bis Nanometerbereich aufweisen. Die keramischen Partikel 13 sind gleichmäßig im Matrixmaterial 11 verteilt. Die keramischen Partikel 13 sind aus Titannitrid gebildet.

Das Halbzeug 10 ist demzufolge aus einem metallischen Matrixmaterial aus Titan oder einer Titanbasislegierung gebildet, wobei in das Matrixmaterial aus Titan oder der Titanbasislegierung einerseits Siliziumcarbidfasern eingelagert sind und wobei andererseits in das Matrixmaterial 11 keramische Partikel 13 aus Titannitrit eingebettet sind. Mithilfe der eingebetteten, keramischen Partikel ist eine Steigerung der Festigkeit des erfindungsgemäßen Halbzeugs 10 gegenüber Torsionsbeanspruchung oder Transversalbeanspruchung realisierbar. Die fein-disperse Verteilung der nanometergroßen bzw. mikrometergroßen Keramikpartikel 13 im Matrixmaterial 11 führt nämlich zu einer Blockierung der in der metallischen Matrix unter Torsionsbeanspruchungen bzw. Transversalbeanspruchungen auftretenden Scherbänder, was in einer Steigerung der Festigkeit des Halbzeugs 10 resultiert. Weiterhin wird eine Rissausbreitung im Matrixmaterial 11 erschwert und somit eine Lebensdauererhöhung ermöglicht. Das erfindungsgemäße Halbzeug 10 verfügt demnach insgesamt gegenüber den aus dem Stand der Technik bekannten Halbzeugen über verbesserte Festigkeitseigenschaften.

Zur Herstellung des Halbzeugs wird, wie nachfolgend beschrieben, vorgegangen:
In einem ersten Schritt werden die zugfesten, zu beschichtenden Fasern, nämlich vorzugsweise Siliziumcarbidfasern, bereitgestellt. Darauffolgend werden die bereitgestellten Siliziumcarbidfasern mit dem Matrixmaterial, also mit Titan oder einer Titanbasislegierung, beschichtet. Das Beschichten der Siliziumcarbidfasern mit Titan oder einer Titanbasislegierung erfolgt im Sinne der hier vorliegenden Erfindung vorzugsweise unter Verwendung eines PVD (Physical Vapor Deposition) Prozesses. Als PVD-Verfahren kommt insbesondere das sogenannte Sputtern, welches auch als Kathodenzerstäuben bezeichnet wird, zum Einsatz. Beim Sputtern wird ein Target aus dem Beschichtungsmaterial, hier aus dem Matrixmaterial, mechanisch zerstäubt und das so zerstäubte Matrixmaterial wird auf der zu beschichtenden Siliziumcarbidfaser abgeschieden. Details derartiger PVD-Verfahren sind dem hier angesprochenen Fachmann geläufig.

Im Sinne der hier vorliegenden Erfindung werden die Siliziumcarbidfasern nicht lediglich mit dem Matrixmaterial aus Titan oder der Titanbasislegierung beschichtet, vielmehr werden bei der Beschichtung der zugfesten Fasern mit Titan oder mit der Titanbasislegierung keramische Partikel in die Beschichtung der Fasern eingelagert. Hierzu wird die PVD-Beschichtung unter einer reaktiven Atmosphäre durchgeführt. Die PVD-Beschichtung der Siliziumcarbidfasern mit Titan oder der Titanbasislegierung erfolgt unter einer Stickstoffatmosphäre. Simultan bzw. gleichzeitig zu der Abscheidung des Titans bzw. der Titanbasislegierung auf den Siliziumcarbidfasern erfolgt demzufolge der atomare Einbau von Stickstoffatomen in die metallische Beschichtung der Fasern.

Die Keramikpartikel werden nun entweder in-situ während der PVD-Beschichtung durch eine Reaktion der Stickstoffatome mit den metallischen Legierungskomponenten in der Gasphase mit abgeschieden, oder im Anschluss an die PVD-Beschichtung durch eine nachfolgende thermo-mechanische Behandlung abgeschieden. Bei der Abscheidung reagieren die Stickstoffatome mit dem Titan bzw. der Titanbasislegierung zu keramischem Titannitrid, welches letztendlich die eingelagerten Keramikpartikel bereitstellt.

Die sich beim PVD-Beschichtungsprozess einstellenden, hohen Abkühlraten erlauben eine Einstellung der Partikelgrößen für die eingelagerten Keramikpartikel im Mikrometerbereich bis Nanometerbereich. Gleiches gilt, wenn die Abscheidung der keramischen Partikel durch eine nachfolgende thermo-mechanische Behandlung erfolgt.

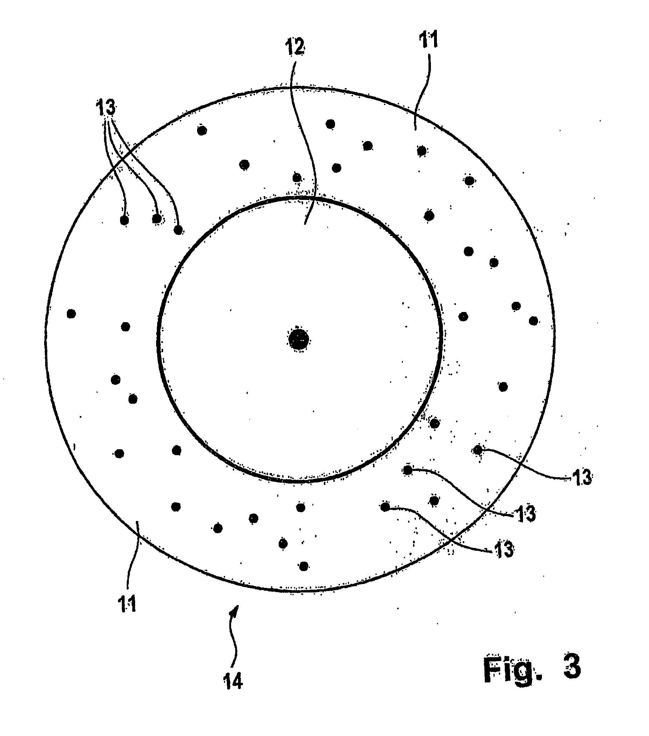

Nach der obigen Beschichtung der Fasern liegen demnach mit Titan oder einer Titanbasislegierung beschichtete Siliziumcarbidfasern vor, wobei in die Beschichtung der Fasern die keramischen Partikel eingelagert sind. Fig. 3 zeigt eine derart mit Titan oder einer Titanbasislegierung beschichtete Faser 14, wobei die eigentliche Faser mit der Bezugsziffer 12, die Beschichtung der Faser 12 mit Titan oder der Titanbasislegierung mit der Bezugziffer 11 und die in das Titan bzw. die Titanbasislegierung eingelagerten Keramikpartikel mit der Bezugsziffer 13 gekennzeichnet sind.

Zur Herstellung des Halbzeugs 10 werden mehrere derart beschichtete Fasern 14 in der gewünschten Geometrie angeordnet und dann wie bei der Herstellung von Halbzeugen aus MMC-Verbundwerkstoff üblich, unter Druckeinwirkung bei hohen Temperaturen zum eigentlichen Halbzeug verdichtet.

## Patentansprüche

1. Verfahren zur Herstellung eines Halbzeugs (10) aus Verbundwerkstoff, bei dem mit Titan oder einer Titanbasislegierung beschichtete sowie zugfeste Fasern (12) durch Druckeinwirkung bei hoher Temperatur zu dem Halbzeug (10) verdichtet werden, **dadurch gekennzeichnet, dass** die Beschichtung der zugfesten Fasern (12) mit Titan oder der Titanbasislegierung unter einer Stickstoffatmosphäre durchgeführt wird, wobei Stickstoffatome zusammen mit Titanpartikeln oder Partikeln der Titanbasislegierung keramische Partikel (13) in Form von Titannitriden in die Beschichtung abscheiden, und wobei die so beschichteten Fasern in einer gewünschten Geometrie angeordnet und zu dem Halbzeug verdichtet werden.

2. Verfahren nach Anspruch 1, **dadurch gekennzeichnet, dass** die Beschichtung der zugfesten Fasern (12) als PVD-Beschichtung, vorzugsweise als Sputtern, durchgeführt wird.

## Claims

1. Method for producing a semifinished product (10) from composite material, in which fibres (12) that are coated with titanium or a titanium-based alloy and are also tension-resistant are compacted by the action of pressure at high temperature in order to form the semifinished product (10), **characterised in that** the coating of the tension-resistant fibres (12) with titanium or the titanium-based alloy is carried out in a nitrogen atmosphere, wherein nitrogen atoms together with titanium particles or particles of the titanium-based alloy deposit ceramic particles (13) in the form of titanium nitrides into the coating, and wherein the fibres thus coated are arranged in a desired geometry and are compacted to form the semifinished product.

2. Method according to claim 1, **characterised in that** the coating of the tension-resistant fibres (12) is carried out as PVD coating, preferably as sputtering.

## Revendications

1. Procédé de production d'un produit semi-fini (10) à partir d'un matériau composite, dans lequel des fibres (12) résistant à la traction et revêtues avec du titane ou un alliage à base de titane sont comprimées sous l'action d'une pression à haute température pour donner le produit semi-fini (10), **caractérisé en ce que** le revêtement des fibres (12) résistant à la traction est réalisé avec du titane ou l'alliage à base de titane sous une atmosphère azotée, les atomes d'azote déposant, conjointement avec les particules de titane ou les particules de l'alliage à base de titane, des particules céramiques (13) sous la forme de nitrures de titane dans le revêtement et les fibres ainsi revêtues étant disposées en une forme géométrique voulue et comprimées pour donner le produit semi-fini.

2. Procédé selon la revendication 1, **caractérisé en ce que** le revêtement des fibres (12) résistant à la traction est réalisé sous la forme d'un revêtement PVD, de préférence sous forme de pulvérisation.
